# EUROPÄISCHE PATENTSCHRIFT

(11) **EP 0 408 572 B1**
(45) Veröffentlichungstag und Bekanntmachung des Hinweises auf die Patenterteilung: **02.06.1993**
(21) Anmeldenummer: 89902514.2
(22) Anmeldetag: 18.02.1989
(51) Int. Cl.: H01L 35/08

(54) **THERMOGENERATOR**
THERMOGENERATOR
THERMOGENERATEUR

(30) Priorität: 22.02.1988 CH 646/88; 01.07.1988 CH 2511/88
(43) Veröffentlichungstag der Anmeldung: 23.01.1991
(73) Patentinhaber: Migowski, Friedrich-Karl, D-75365 Calw (DE)
(72) Erfinder: Migowski, Friedrich-Karl, D-75365 Calw (DE)
(74) Vertreter: Hubbuch, Helmut, Dipl.-Ing
(86) Internationale Anmeldenummer: EP8900152
(87) Internationale Veröffentlichungsnummer: WO8907836

(56) Entgegenhaltungen:
- GB-A- 1 381 001
- US-A- 3 554 815
- US-A- 3 648 470
- US-A- 4 677 416
- Patent Abstracts of Japan, Vol. 11, No. 110 (E-496)(2557) 07 April 1987, & JP,A,61259580

## Beschreibung

Die Erfindung betrifft einen Thermogenerator mit p und n Elementen für eine Uhr, einen Sensor, ein Stromspeisegerät oder dgl., der zwischen einer warmen und kalten Temperaturquelle angeordnet ist, wobei die Thermoelemente mit einer Dünn- oder Dickfilmtechnik auf ein Substrat aufgetragen sind und die Form der n und p Elementen so gewählt ist, dass sie sich untereinander überschneiden.

Ein bekannter Thermogenerator ist in der CH-PS 604249 beschrieben. Dieser ist aus diskreten Bauteilen zusammengesetzt, indem thermoelektrisches Material in Stäbchen geschnitten wird, um dann zu Blöcken zusammengesetzt zu werden. Dadurch können in einer Uhr nur einige hundert von thermoelektrischen Elementen in Serie geschaltet werden.

Die Ausgangsspannung ist zu klein um eine Batterie mit Strom zu versorgen. Dieser muss noch durch eine aufwendige Elektronik und durch einen Transformer auf ein Niveau gebracht werden, um eine Batterie laden zu können.

In der PS GB-A-1 381001 ist die Herstellung eines Dünnfilmthermogenerators auf eine Aluminium und Aluminiumoxydunterlage beschrieben. Diese Herstellung eignet sich nur eine sehr kleine Anzahl von Thermoelementen. Zudem ist die Herstellung des Substrats sehr aufwendig.

In der PS US-A-3648470 ist ein Peltier Element beschrieben zur Heizung oder Kühlung eines Teiles. Dabei überlappen die p und n Elemente sich gegeneinander und zwischen der Ueberlappung ist ein Material vorgesehen, das elektrisch gut, jedoch thermisch nicht leitet.

Bei der Herstellung von Dünn- oder Dickschichten ist es jedoch wichtig ein Material, das die p und n Elemente verbindet, so zu wählen, dass es metallurgisch eine Verbindung hervorgibt, die eine gute Haftbarkeit, kleinen elektrischen Widerstand und eine gute Wärmeleitfähigkeit ergibt.

Die in den PS JP-A-61 259 580 und US-A-4 677 416 beschreibenen mit einer Dünnfilmtechnik aufgetragene Schichten, überlappen sich gegenseitig. Da es sich dabei immer nur um wenige Paare handelt, ist die Grösse des elektrischen Gesamtwiderstandes kein Problem. Eine solche Ausführung ist jedoch bei einer Serieschal tung von mehreren Tausen Elementenpaare nicht denkbar, da der elektrische Widerstand viel zu hoch wäre. Auch wurden die intermetallischen Probleme bei den Metallübergängen nicht berücksichtigt.

Die PS US-A-3 554 815 beschreibt eine Lösung, in der die p-Schicht auf der einen Seite und die n-Schicht auf der anderen Seite eines Substrats aufgebracht werden. Dies wäre bei einer Serieherstellung viel zu kostspielig. Auch ist das im Patentanspruch angegebene Verhältnis von 5 : 1 zwischen der Schichtdicke und der Substratdicke bei Dünnschichten nicht ausführbar. Dieses Verhältnis ist eher 1 : 1 für Anwendungen die nachher beschrieben werden.

Es ist daher Aufgabe der Erfindung einen Thermogenerator herzustellen, der mit einfachen Mitteln, kostengünstig und in grossen Serien herstellbar ist.

Dies wird nach den kennzeichnenden Teilen der Patentansprüche 1 und 4 erreicht.

Die Herstellung des Thermogenerators benötigt nur eine Maske, die nach der Herstellung von z.B. der p Elementen um 180° gedreht wird um dann die n Elemente aufzutragen.

Dabei entstehen automatisch Ueberlappungen von n und p Materialien. Damit der elektrische Widerstand reduziert werden kann, ist eine zusätzliche Schicht eines Materials aufzutragen, das sich mit dem n und p Material der Thermoelemente metallisch verbindet. Dadurch wird die thermoelektrische Spannung des Generators nicht beeinflusst, jedoch der Wirkungsgrad deutlich verbessert, durch diese Reduktion des elektrischen Widerstands. Gleichzeitig werden mit dem gleichen Arbeitsgang und mit den gleichen Materialien Kontaktflächen aufgetragen, damit das erste und letzte Element des Thermogenerators mit einer Schaltung verbunden werden können. Ein anderes Problem ist die Wärmeübertragung von den Wärmequellen auf das Substrat. Durch das Auftragen einer zusätzlichen Schicht ist es möglich durch die Anwendung einer entsprechenden Wärmeleitpaste oder dgl. eine optimale Wärmeübertragung herzustellen. Da die Verluste der Wärmeübertragung durch das Substrat, die Befestigung und durch die Luft nicht unbedeutend sind, ist diese Lösung der Aufgabe von grosser Bedeutung.

Die Schicht zur Verbesserung der Wärmeübertragung kann vorteilhafterweise aus dem gleichen Material hergestellt werden, wie dasjenige das für die Kontaktflächen oder für die zusätzlichen leitenden Schichten verwendet wird.

Einer der wichtigsten Verlustquellen bei der Wärmeübertragung ist gegeben durch den Abstand beider Quellen. Die Luft überträgt die Wärme relatif gut und das Volumen zwischen den Quellen kann gross sein. Um diesen Verlst zu reduzieren, ist es von Vorteil, Plastikfolien auf die Flächen aufzubringen, die mit der Luft im Kontakt sind, um die Wärmeübertragung zwischen den Quellen und der Luft zu vermindern.

Besonders in einer Uhr, wo die Temperaturdifferenz zwischen den beiden Temperaturquellen gering ist, z.B. 3-5 °C sind die vorgeschlagenen Lösungen sehr wirkungsvoll.

Bei der Anwendung eines Thermogenerators in einer Uhr ist es so, dass das Uhrwerk meistens rund ist. Bei einer rechteckigen Schale ist es von Vorteil, den Thermogenerator in die 4 Ecken unterzubringen. Bei einem Dünnfilmgenerator sind ca. 1000 Elementenpaare in Serie geschaltet. Total ergeben die 4000 Paare in Serie geschaltet eine Spannung ab von ca.1,5Volt, um einen Akkumulator oder einen Kondensator mit einer Kapazität von etwa 1 F aufzuladen. Ein Thermogenerator mit 1000 Paare hat eine Länge von ca. 30 cm.

Er muss daher aufgerollt werden, um in einer Uhr eingebaut werden zu können.

Die Herstellung der Dünnfilme kann durch Aufdampfen, Kathodenzerstäubung oder durch Flashaufdampfen erfolgen.

Bei den Dickfilmen kann der Siebdruck oder ein anderes Druckverfahren verwendet werden. Ist nach dem Auftragen der thermoelektrischen Elemente eine thermische Behandlung notwendig, ist es von Vorteil als Substrat Glimmer oder eine Keramik zu verwenden. Andernfalls ist ein Kunststoff vom Typ Polyimid oder Polyterephtalat vorzuziehen, die unter der Handelsbezeichnung Kapton oder Mylar im Handel erhältlich sind. Auch bei diesen ist eine beschränkte thermische Behandlung möglich. Die Dicke des Substrats sollte möglichst dünn gewählt werden, um den thermischen Kurzschluss auf ein Minimum zu reduzieren. Der thermische Wirkungsgrad wird verbessert, wenn beidseitig vom Substrat thermoelektrische Elemente aufgetragen werden.

Anstelle der Verwendung einer Maske kann auch das thermoelektrische Material auf dem ganzen Substrat aufgetragen werden. Durch eine chemische Aetzung oder durch einen Ionenstrahl kann die gewünschte Geometrie angefertigt werden.

Die n und p Thermoelemente können aus bekannten Materialien, wie Bi, Te, Sb, Se oder Pb, Se oder Pb, Te oder anderen Legierungen hergestellt werden.

Bei einer thermoelektrischen Uhr kann das Substrat um das Uhrwerk angeordnet sein oder die einzelnen Substrate können in der Uhrenschale an günstigen Orten untergebracht werden.

Der Strom der Thermogeneratoren kann einen Kondensator oder einen Akkumulator direkt aufladen. Der Akkumulator hat den grossen Nachteil, dass er einen Elektrolyt enthält. Dadurch ist es schwierig einen Akkumulator auf längere Zeit dicht zu halten. Mit den heutigen Elektrolyten KOH und NaOH ist es praktisch unmöglich einen Akkumulator während mindestens 10 Jahren dicht zu halten. Diese Nachteile sind bei dem Kondensator nicht vorhanden.

Neben der beschriebenen Anwendung des erfindungsgemässen Thermogenerators in einer Uhr , kann dieser auch in Sensoren, Stromspeisegeräten usw. eingesetzt werden. Bedingt durch die verlangten Energiesparmassnahmen in der Heizung ist es von Vorteil, einen Wärmefluss zu messen. Dabei erzeugt ein Thermogenerator genügend Strom und Spannung um eine elektronische Schaltung zu speisen und ein Integrator kann die Wärmemenge messen, die in einem elektronischen Gedächnis dann gespeichert werden kann. Dabei wird die Verwendung einer Lithiumbatterie überflüssig, die zudem periodisch ausgewechselt werden muss.

Solche Sensoren können eine Anwendung finden in Grossheizanlagen und Mietwohnungen. Jedoch auch in industriellen Anlagen zur vollautomatischen Ueberwachung von Temperaturvorgängen, die unabhängig von der Netzspannung oder einer Batterie funktionieren müssen.

Ein Ausführungsbeispiel der Erfindung ist in den Figuren dargestellt.

Es zeigen:
- Fig.1a und 1b: die n und p Elemente einzeln dargestellt.
- Fig.2: Thermogenerator mit den Kontaktflächen
- Fig.3: Montierter Thermogenerator
- Fig.4: Substrat mit Thermogenerator

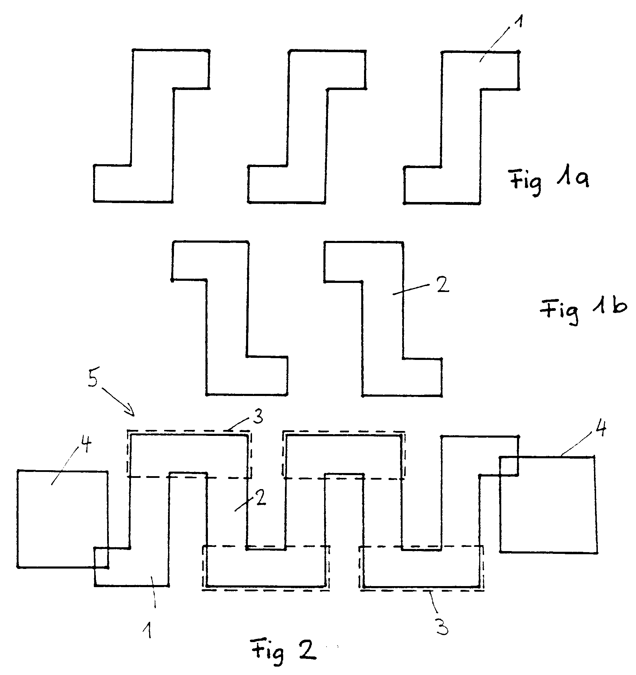

Fig. 1a zeigt n Elemente hergestellt mit einer Maske und Fig. 1b die p Elemente, hergestellt mit der gleichen Maske, wobei letztere um 180° gedreht wurde. Wenn nun die n und p Elemente 1,2 am gleichen Ort auf ein Substrat aufgetragen werden erhält man einen Thermogenerator, wie er in Fig,2 dargestellt ist. Um den elektrischen Widerstand des Thermogenerators 5 zu verkleinern werden zusätzliche Schichten 3 auf die Kontaktflächen der n und/oder p Elementen aufgetragen.

Mit der gleichen Legierung, wie die Schichten 3 werden Kontaktflächen 4 aufgebracht. Diese Schichten 3 und die Kontaktflächen 4 bestehen aus einem Material, das mit den n und p Elementen 1,2 metallisch löslich ist. Durch die Kontaktflächen 4 ist es möglich den Thermogenerator 5 mit einer elektrischen Schaltung zu verbinden.

### Beispiel einer Anwendung in einer Uhr:

### Dimensionen eines p oder n Elements:

Schichtdicke: 0,005 mm, Schichtbreite: 0,1 mm, Schichtlänge: 0.75 mm, spezifischer elektrischer Widerstand: 0,00001 ohm.m. Daraus ergibt sich einen elektrischen Widerstand pro Elementenpaar von 30 Ohm. Bei 7500 in Serie geschalteten Elementenpaare ist der Widerstand 225 kOhm. Dieser Widerstand kann durch die zusätzlichen Schichten um 2 - 40% reduziert werden. Bei einer Temperaturdifferenz von 6 °C kann eine Klemmenspannung von ca. 1,6 V erwartet werden. Ein solcher Generator kann eine Leistung von 11 mikrowatt abgeben.

Es ist auch denkbar, dass die Thermoelemente in einem Uhrenarmband untergebracht sein könnten, das eine mit dem Arm thermisch isolierte Oberfläche aufweist. Der Thermogenerator ist dann mit elektrischen Leitern mit dem Kondensator oder dem Akkumulator der Uhr verbunden. Anstelle einer Uhr könnte man sich ein tragbares Instrument vorstellen, wie ein Pulsmesser, Blutdruckmessgerät, elektronisches Höhenmessgerät, Thermometer, elektronischen Kompass usw.

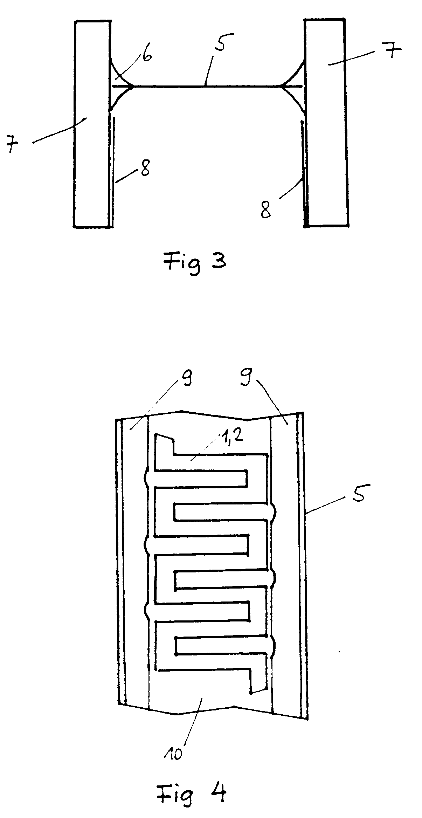

Fig. 3 stellt einen Thermogenerator 5 dar, der zwischen den beiden Temperaturquellen 7 angeordnet ist. Um die Wärmeübertragung zu optimalisieren, wird ein Material 6 zwischen den Temperaturquellen 7 und dem Thermogenerator 5 aufgetragen. Dieses Material muss die Wärme möglichst gut leiten, um die Wärmeübertragung von den Quellen 7 auf den Thermogenerator 5 zu fördern. Dieses Material kann ein Elastomer sein in einem weichen oder ausgehärteten Zustand und kann eine relativ grossen Anteil Pulver enthalten, das die Wärme leitet.

Bei einem Thermogenerator sollte möglichst viel Wärme durch die Thermoelemente 1,2 fliessen. Um dies zu erreichen, sollten die Verluste durch parallele Wärmebrücken möglichst reduziert werden. Dabei spielt der Wärmeverlust durch die Luft eine wichtige Rolle. Dieser Wärmeverlust kann reduziert werdendurch das aufbringen von zusätzlichen Folien 8 auf eine oder beide Temperaturquellen 7.

Fig. 4 stellt ein Substrat 10 dar, auf dem Thermoelemente 1,2 aufgetragen wurden. Zusätzlich wurde noch eine Schicht 9 aufgetragen, die die Thermoelemente 1,2 nicht berühren.

Diese Schicht 9 kann aus Metall sein oder aus dem gleichen Material, wie die Verbindungsschichten 3 sein. Diese Schicht 9 hat den Vorteil, dass die Wärmeübertragung von den Quellen 7 verbessert wird, zwischen denen schon das Wärmeübertragungsmaterial 6 vorhanden ist.

## Patentansprüche

1. Thermogenerator mir p und n Elementen für eine Uhr, einen Sensor, ein Stromspeisegerät, der zwischen einer warmen und einer kalten Temperaturquelle (7) angeordnet ist, wobei die Thermoelemente (1,2) mit einer Dünn- oder Dickfilmtechnik auf ein Substrat (10) aufgetragen sind und die Form der n und p Elemente (1,2) so gewählt ist, dass sie sich untereinander überschneiden und das erste und das letzte in Serie geschaltete Element mit einer Kontaktfläche (4) verbunden ist, dadurch gekennzeichnet, dass eine zusätzlich elektrisch leitende Schicht (3) auf die Kontaktfläche der p und n Elemente (1,2) aufgetragen ist, um den elektrischen Widerstand des Thermogenerators zu reduzieren.

2. Thermogenerator nach Anspruch 1, dadurch gekennzeichnet, dass die leitende Schicht (3) und/oder die Kontaktfläche (4) aus einem Metall oder einer Legierung besteht, die mit dem Material der Elemente (1,2) metallisch löslich ist.

3. Thermogenerator nach Anspruch 1 oder 2, dadurch gekennzeichnet, dass das Substrat (10) beidseitig mit Thermoelementen beschichtet ist.

4. Thermogenerator nach einem der Ansprüche 1 bis 2, dadurch gekennzeichnet, dass der Wärmefluss zwischen den beiden Quellen (7) mindestens teilweise über zusätzliche Wärmebrücken (6,9), die zwischen den Quellen (7) und den Thermoelementen (1,2) liegen, geführt ist (Fig. 4).

5. Thermogenerator nach Anspruch 4, dadurch gekennzeichnet, dass die Wärmebrücke (6) aus einem thermisch leitenden, elektrisch isolierenden Material, wie ein Elastomer, dem ein thermisch leitendes Pulver zugemischt worden ist, zwischen den Quellen (7) und den Substrat (10) aufgebracht ist und/oder aus einem Metall (9), das parallel zu der Längsichtung des Substrats (10) auf letzteres aufgebracht ist, um die Wärmeübertragung zwischen den Quellen (7) und den Thermoelementen (1,2) zu verbessern.

6. Thermogenerator nach einem der Ansprüche 1 bis 5, dadurch gekennzeichnet, dass Isolationsfolien (8) auf die Quellen (7) aufgebracht sind, um den Wärmeverlust durch die Luft zu reduzieren.

7. Uhr mit einem Thermogenerator nach einem der Ansprüche 1 bis 6, dadurch gekennzeichnet, dass ein oder mehrere Thermogeneratoren (5) um das Uhrwerk angeordnet sind oder dass mehrere Thermogeneratoren (5) verteilt und untereinander elektrisch verbunden um das Uhrwerk angeordnet sind.

8. Uhr nach Anspruch 7, dadurch gekennzeichnet; dass der oder die Thermogeneratoren (5) aufgerollt sind.

9. Uhr nach Anspruch 7 oder 8, dadurch gekennzeichnet, dass sie mit einem Kondensator ausgerüstet ist, der durch den Thermogenerator aufladbar ist und das Uhrwerk mit Strom versorgt.

10. Sensor mit einem Thermogenerator nach einem der Ansprüche 1 bis 6, dadurch gekennzeichnet, dass ein Integrator vorgesehen ist, um eine Wärmemenge zu messen.

## Claims

1. A thermogenerator having p and n elements for a clock, a sensor, a current feeding apparatus
arranged between a hot and a cold temperature source (7), the thermoelements (1,2) being applied on the substrate (10) by a thin-film or a thick-film process and the shape of the n and p elements (1,2) being selected in such a way that they overlap each other, and the first and the last series-connected elements being connected to a contact surface (4) characterized in that an additional electrically conductive layer (3) is applied on the contact surface of the p and n elements (1,2) in order to reduce the electric resistance of the thermogenerator.

2. A thermogenerator according to claim 1, characterized in that the said conductive layer (3) and/or the said contact surface (4) consists of a metal or of an alloy which is metallically soluble with the material of the elements (1,2).

3. A thermogenerator according to claim 1 or 2, characterized in that the said substrate (10) is coated with thermoelements on both sides.

4. A thermogenerator according to any of claims 1 to 2, characterized in that the heat flow between the two sources (7) is conducted, at least partly, across additional heat bridges (6,9) arranged between the said sources (7) and the said thermoelements (1,2) (Fig. 4).

5. A thermogenerator according to claim 4, characterized in that the said heat bridge (6) consists of a thermally conductive, electrically insulating material, such as an elastomer, which contains an admixture of a thermally conductive powder and has been applied between the said sources (7) and the said substrate (10), and/or of a metal (9) which has been applied on the said substrate (10) in parallel to the latter's longitudinal direction, in order to improve the heat transmission between the said sources (7) and the said thermoelements (1,2).

6. A thermogenerator according to any of claims 1 to 5, characterized in that insulating films (8) are applied on the said sources (7) for the purpose of reducing heat losses through the air.

7. A clock comprising a thermogenerator according to any of claims 1 to 6, characterized in that one or more thermogenerators (5) are arranged around the clock or that a plurality of thermogenerators (5), which are electrically interconnected, are arranged around the clock.

8. A clock according to claim 7, characterized in that the said one or more thermogenerators (5) are rolled up.

9. A clock according to claim 7 or 8, characterized in that the said clock is provided with a capacitor which is arranged for being charged by the said thermogenerator and for supplying the clockwork with current.

10. A sensor comprising a thermogenerator according to any of claims 1 to 6, characterized in that there is provided an integrator for measuring an amount of heat.

## Revendications

1. Générateur thermoélectrique à éléments p et n pour une horloge, un capteur, un appareil d'alimentation en courant, disposé entre des sources de température chaude et froide (7), les thermoéléments (1,2) étant appliqués sur un substrat par une technique en couche mince ou en couche épaisse et la forme des éléments p et n (1,2) étant choisie de telle sorte qu'ils se chevauchent mutuellement et que le premier et le dernier éléments raccordés en série sont reliés à une surface de contact (4), caractérisé en ce qu'une couche électriquement conductrice additionnelle (3) est appliquée sur la surface de contact des éléments p et n (1,2) pour réduire la résistance électrique du générateur thermoélectrique.

2. Générateur thermoélectrique selon la revendication 1, caractérisé en ce que la couche conductrice (3) et/ou la surface de contact (4) est en un métal ou un alliage qui forme une solution métallique avec le matériau des éléments (1,2).

3. Générateur thermoélectrique selon l'une des revendications 1 et 2, caractérisé en ce que le substrat (10) est recouvert de thermoéléments sur ses deux faces.

4. Générateur thermoélectrique selon l'une des revendications 1 à 2, caractérisé en ce que le flux de chaleur entre les deux sources (7) est conduit au moins partiellement par des ponts thermiques additionnels (6,9) situés entre les sources (7) et les thermoéléments (1,2) (fig. 4).

5. Générateur thermoélectrique selon la revendication 4, caractérisé en ce que le pont thermique (6) est introduit entre les sources (7) et le substrat (10), en un matériau thermiquement conducteur et électriquement isolant, tel qu'un élastomère, auquel on a mélangé une poudre thermiquement conductrice, et/ou en un métal (9) qui est étendu sur le substrat (10), parallèlement à la direction longitudinale de ce dernier, pour améliorer le transfert de chaleur entre les sources (7) et les thermoéléments (1,2).

6. Générateur thermoélectrique selon l'une des revendications 1 à 5, caractérisé en ce que des feuilles isolantes (8) sont étendues sur les sources (7) pour réduire les pertes thermiques par l'air.

7. Horloge comprenant un générateur thermoélectrique selon l'une des revendications 1 à 6, caractérisée en ce qu'un ou plusieurs générateurs thermoélectriques (5) sont disposés autour du mécanisme d'horloge ou que plusieurs générateurs thermoélectriques (5) sont répartis autour du mécanisme d'horloge et reliés électriquement les uns aux autres.

8. Horloge selon la revendication 7, caractérisée en ce que le ou les générateurs thermoélectriques (5) sont enroulés.

9. Horloge selon l'une des revendications 7 et S, caractérisée en ce qu'elle est équipée d'un condensateur qui peut être chargé par le générateur thermoélectrique et alimente l'horloge en courant.

10. Capteur comprenant un générateur thermoélectrique selon l'une des revendications 1 à 6, caractérisé en ce qu'il est prévu un intégrateur pour mesurer une quantité de chaleur.
